(19) Europäisches Patentamt
European Patent Office
Office européen des brevets

(11) Veröffentlichungsnummer: **0 254 128**
**A2**

(12) **EUROPÄISCHE PATENTANMELDUNG**

(21) Anmeldenummer: **87109817.4**

(22) Anmeldetag: **07.07.87**

(51) Int. Cl.⁴: **G01N 23/225**

(30) Priorität: **25.07.86 DE 3625198**

(43) Veröffentlichungstag der Anmeldung:
**27.01.88 Patentblatt 88/04**

(84) Benannte Vertragsstaaten:
**DE FR GB IT NL**

(71) Anmelder: **Siemens Aktiengesellschaft Berlin und München**
**Wittelsbacherplatz 2**
**D-8000 München 2(DE)**

(72) Erfinder: **Plies, Erich, Dr.**
**Deisenhofener Strasse 79 c**
**D-8000 München 90(DE)**

(54) **Verfahren und Anordnung zur aufladungsfreien Untersuchung einer Probe.**

(57) Zur Inspektion und Vermessung feinster Strukturen in der Mikroelektronik und der integrierten Optik werden immer häufiger Rastermikroskope eingesetzt. Um unverzerrte und hochauflösende Abbildungen der im allgemeinen aus verschiedenen Materialkomponenten bestehenden Proben zu gewährleisten, müssen Aufladungen nichtoder schlechtleitender Oberflächen durch den abtastenden Primärstrahl vermieden werden. Es wird deshalb vorgeschlagen, die Probe mit Korpuskeln abzutasten, deren Energie oberhalb der höchsten Neutralpunktenergie aller Oberflächenmaterialien liegt. Die durch den Primärstrahl aufgebrachten negativen Ladungen werden durch Bestrahlung der Probe mit UV-Licht reduziert bzw. bei genügend hoher Strahlungsintensität vollständig abgebaut.

FIG 1

EP 0 254 128 A2

## Verfahren und Anordnung zur aufladungsfreien Untersuchung einer Probe

Die Erfindung betrifft ein Verfahren zur aufladungsfreien Untersuchung einer Probe nach dem Oberbegriff des Patentanspruchs 1, sowie eine Anordnung zur Durchführung des Verfahrens nach dem Oberbegriff des Patentanspruchs 9.

Zur Inspektion und Vermessung feinster Strukturen in der Mikroelektronik und integrierten Optik werden immer häufiger Rastermikroskope eingesetzt. Um unverzerrte und hochauflösende Abbildungen der im allgemeinen aus verschiedenen Materialkomponenten bestehenden Proben zu gewährleisten, müssen Aufladungen nicht-oder - schlechtleitender Oberflächen durch den abtastenden Primärstrahl vermieden werden.

Es ist bekannt, die Proben zur Erzeugung einer ausreichend hohen Oberflächen-bzw. Volumenleitfähigkeit mit einer dünnen Metallschicht zu bedampfen. Eine solche Bedampfung ist allerdings nicht möglich, wenn die Probe nach ihrer Untersuchung wiederverwendet oder einer Weiterbehandlung unterzogen werden soll. Um auch nichtbeschichtbare Proben, insbesondere integrierte Schaltungen, weitgehend aufladungsfrei im Rasterelektronenmikroskop untersuchen zu können, betreibt man diese Geräte im Niederspannungsbereich, d. h. bei kleinen Primärelektronenenergien zwischen 1 und 3 keV. Da die während der Messungen konstantgehaltene Energie der Primärelektronen i. A. nicht mit der material-und topographieabhängigen Neutralpunktenergie des jeweils abgetasteten Oberflächen bereichs übereinstimmt, sind lokale Aufladungen unvermeidbar.

Aus dem IBM Technical Disclosure Bulletin, Vol. 27, No. 11 (April 85), Seiten 6388-6389 ist ein Verfahren zur Entladung eines mit dem Schreibstrahl eines Elektronen-Lithografiegerätes abgetasteten Halbleiterwafers bekannt. Die Ableitung der Oberflächenladungen erfolgt hierbei über eine durch Bestrahlung mit Licht erzeugte fotoleitende Schicht zwischen der geerdeten Waferhalterung und dem Auftreffpunkt des rasternden Elektronenstrahles.

Der Erfindung liegt die Aufgabe zugrunde, ein Verfahren der eingangs genannten Art und eine Anordnung zur Durchführung des Verfahrens anzugeben, mit dem nicht-oder schlechtleitende Oberflächenbereiche einer zu untersuchenden Probe nahezu aufladungsfrei mit einem Sekundärkorpuskeln auslösenden Primärstrahl abgetastet werden können. Das Verfahren sollte insbesondere auch für die aufladungsfreie Untersuchung der gegenüber induzierten Strömen störanfälligen integrierten Schaltungen geeignet sein.

Diese Aufgabe wird erfindungsgemäß durch ein Verfahren nach Patentanspruch 1 und eine Anordnung nach Patentanspruch 9 gelöst.

Der mit der Erfindung erzielbare Vorteil besteht insbesondere darin, daß die zu untersuchenden Proben aufladungsfrei abgetastet und verzerrungsfrei abgebildet werden können.

Während die Ansprüche 2 bis 8 bevorzugte Ausgestaltungen des Verfahrens nach Anspruch 1 betreffen, sind die Ansprüche 10 und 11 auf vorteilhafte Anordnungen zur Durchführung des Verfahrens gerichtet.

Die Erfindung wird nachfolgend anhand der Zeichnungen näher erläutert. Dabei zeigt:

Fig. 1 ein Ausführungsbeispiel einer erfindungsgemäßen Anordnung zur aufladungsfreien Untersuchung einer Probe,

Fig. 2 die Ausbeute emittierter Elektronen in Abhängigkeit von der Energie der Primärelektronen.

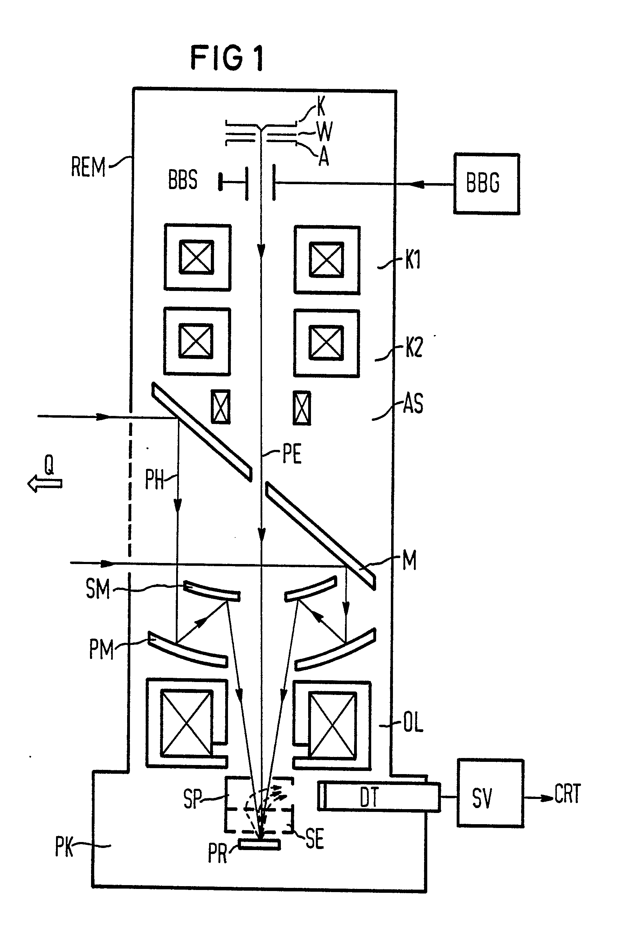

Die in Fig. 1 dargestellte Anordnung zur aufladungsfreien Untersuchung einer Probe besteht im wesentlichen aus einem eine elektronenoptische Säule, eine Detektoreinheit DT und eine Anordnung zur Signalverarbeitung SV aufweisenden Rasterelektronenmikroskop REM, einer in Fig. 1 nicht dargestellten Strahlungsquelle Q und einer oberhalb der Objektivlinse OL angeordneten Optik (M, SM, PM) zur Fokussierung der von der Quelle Q ausgehenden Strahlung PH auf die Probe PR. Die elektronenoptische Säule ist im wesentlichen aus einem eine Kathode K, eine Wehnelt-Elektrode W und eine Anode A aufweisenden Strahlerzeuger, einem Linsensystem (K1, K2, AS, OL) zur Formung, Ablenkung und Fokussierung des Primärelektronenstrahles PE und einer Vielzahl nicht dargestellter Blenden zur Verbesserung der Abbildungseigenschaften aufgebaut. Zur Erzeugung einer Elektronensonde mit kleinen Querschnitt werden die von der Kathode K emittierten und in Richtung der Anode A beschleunigten Elektronen in einem ersten Strahlüberkreuzungspunkt (Quellen-crossover) fokussiert. Dieses Zwischenbild der Elektronenquelle bildet dann anschließend mit Hilfe der Kondensorlinsen K1, K2 und der Objektivlinse OL stark verkleinert auf die Probe PR ab, wobei sich die Bahnen der Primärelektronen nach Durchlaufen der Kondensorlinsen K1, K2 in weiteren Stahlüberkreuzungspunkten schneiden. In einem dieser Stahlüberkreuzungspunkte wird vorteilhafterweise ein über einen Pulsgenerator BBG angesteuertes Stahlaus tastsystem BBS angeordnet. Die Positionierung des Primärelektronenstrahles PE auf einem nicht näher bezeichneten Punkt der Probe PR bzw. dessen zeilenförmige Ablenkung über deren Oberfläche erfolgt mit Hilfe einer Ablenkeinheit AS, die über einen nicht dargestellten Rastergenerator mit Ablenkspannungen versorgt wird. Zum Nachweis der auf der Probe PR von den hochenergetischen Primärelektronen aufgrund ihrer Wechselwirkung mit dem Festkörper ausgelösten Sekundärelektronen SE ist das Rasterelektronenmikroskop REM im allgemeinen mit einer aus Abschirmgitter, Szintillator und Lichtleiter bestehenden Detektoreinheit DT ausgestattet, deren in der Anordnung zur Signalverarbeitung SV verstärktes Ausgangssignal beispielsweise die Intensität des Schreibstrahles eines Sichtgerätes CRT steuert. Bei quantitativen Potentialmessungen ist der Detektoreinheit DT ein zwischen der Objektivlinse OL und der Probe PR angeordnetes Gegenfeld-Spektrometer SP vorgeschaltet, das im allgemeinen eine Absaugelektrode, eine oder mehrere ebene oder halbkugelförmige Gegenfeldelektroden und eine Ablenkelektrode zur Beschleunigung der Sekundärelektronen SE in Richtung des Detektors DT aufweist.

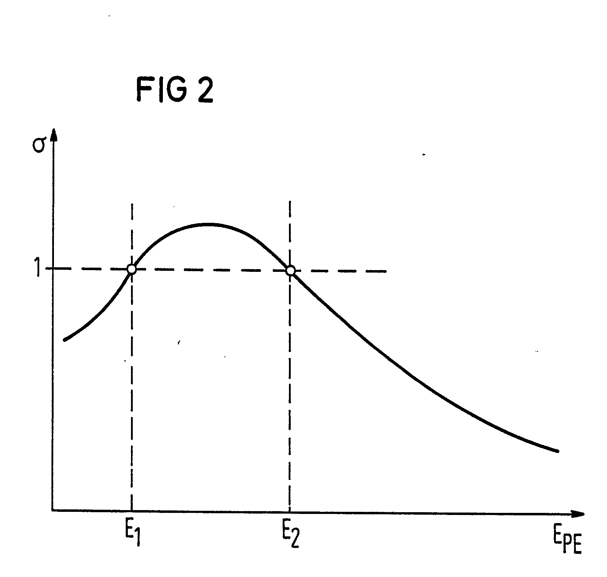

Es ist bekannt, daß der Primärelektronenstrahl PE den Ladungszustand des jeweils abgetasteten Oberflächenbereiches der Probe PR beeinflußt. Dieses Phänomen wird im folgenden anhand der Fig. 2 erläutert, in der die Ausbeute emittierter Elektronen $\delta$ (mittlere Zahl der pro einfallenden Primärelektronen auf der Probe ausgelösten Sekundär-und Rückstreuelektronen) in Abhängigkeit von der Energie $E_{PE}$ der Primärelektronen schematisch dargestellt ist. Diese den Aufladeprozeß bestimmenden Größe $\delta$ steigt bei niedrigen Primärelektronenenergien stark an, erreicht üblicherweise ein Maximum und fällt bei höheren Primärelektronenenergien langsam wieder ab. In dem in Fig. 2 dargestellten Diagramm existieren zwei Primär elektronenenergien $E_1$, $E_2$ bei denen sich der auf die Probe auftreffende Primärelektronenstrom und der von der Probe ausgehende Strom der Sekundär-und Rückstreuelektronen gerade kompensieren, bei denen jedes auftreffende Primärelektron also gerade ein Elektron auslöst ($\delta = 1$). Diese materialabhängigen Neutralpunktenergien sind mit $E_1$ und $E_2$ (untere bzw. obere Neutralpunktenergie) bezeichnet, wobei $E_1$ im allgemeinen unterhalb 0,5 keV und $E_2$ mit wenigen Ausnahmen im Energiebereich zwischen etwa 0,5 und 4 keV liegt. Bestrahlt man die Probe mit Primärelektronen, deren Energie E $_{PE}$ nicht mit einer der Neutralpunktenergien $E_1$ und $E_2$ übereinstimmt, laden sich nichtleitende Oberflächenbereiche allmählich positiv ($E_1 < E_{PE} < E_2$, $\delta > 1$) oder negativ ($E_{PE} > E_2$, $\delta < 1$) bis zum Erreichen eines Gleichgewichtszustandes auf. Dieser Gleichgewichtszustand ist erreicht, wenn die Primärelektronen in dem durch die aufgebrachten Ladungen erzeugten elektrischen Feld soviel kinetische Energie gewinnen bzw. verlieren, daß deren Auftreffenergie gerade mit der für das jeweilige Oberflächenmaterial charakteristischen Neutralpunktenergie übereinstimmt.

Erfindungsgemäß ist eine nahezu aufladungsfreie Untersuchung einer Probe in einem Rasterelektronenmikroskop gewährleistet, wenn man deren vom Primärstrahl abgetastete Oberflächenbereiche zusätzlich mit Licht, insbesondere UV-Licht bestrahlt. Ist die Wellenlänge des Lichtes kleiner aus die Grenzwellenlänge λgr für den äußeren Fotoeffekt, kann eine durch den Elektronenstrahl aufgebrachte negative Überschußladung durch Emission von Fotoelektronen und der vom Primärstrahl ausgelösten Sekundärelektronen abgebaut werden, wobei die Stromdichte der Fotoelektronen von der Wellenlänge bzw. der spektralen Zusammensetzung des Lichtes, von der Bestrahlungsstärke (Intensität) und vom Material der Oberfläche abhängt. Um hohe Fotoelektronenausbeuten zu erreichen, verwendet man vorteilhafteweise Licht aus den nahen und mittleren UV-Bereich (2000 Å $< \lambda <$ 3000 Å). Positive Aufladungen der Probe durch den Elektronenstrahl werden vermieden, wenn man dessen Energie $E_{PE}$ geringfügig oberhalb der höchsten oberen Neutralpunktenergie $E_2$ aller Oberflächenmaterialen wählt ($E_{PE} \geq E_{2max}$, $\delta < 1$). Dies hat zur Folge, daß sich die aus dem entsprechenden Material bestehenden Oberflächenbereiche nicht, die aus anderen Materialen mit niedrigeren Neutralpunktenergien $E_2$ bestehenden Oberflächenbereiche aber negativ aufladen. Negative Ladungen kann man dann wie oben beschrieben durch Bestrahlung der Probe mit Licht geeigneter Wellenlänge $\lambda < \lambda gr$ ($\lambda_{gr}$ = Grenzwellenlänge für äußeren Fotoeffekt) reduzieren bzw. bei genügend hoher Strahlungsintensität vollständig abbauen. Bei ausreichend hoher Fotoemission wird eine geringe positive Aufladung der Probe bis auf einige Volt beobachtet. Höhere positive Aufladungen treten allerdings nicht auf, da die mit niedrigen kinetischen Energien im Bereich einiger Elektronenvolt emittierten Fotoelektronen eine in der angegebenen Größenordnung aufgeladene Probe nicht mehr verlassen können.

Bei dem in Fig. 1 dargestellten Ausführungsbeispiel wird das in einer Strahlungsquelle Q erzeugte Licht PH über einen Spiegel M in die elektronenoptische Säule des Rasterelektronenmikroskopes REM eingekoppelt und mit Hilfe einer aus Primär-und Sekundärspiegel PM bzw. SM bestehenden und oberhalb der Objektivlinse OL angeordneten Cassegrain-Optik auf die Probe PR fokussiert. Der Spiegel M und der Sekundärspiegel SM sind hierbei zusätzlich mit Ausnehmungen für den Durchtritt des Elektronenstrahles PE versehen. Anstelle des Cassegrain-Spiegelsystems kann man das Licht selbstverständlich auch mit Hilfe von Lichtleitern, insbesondere Quarzlichtleitern an die Probe PR heranführen. Die ausgelösten Fotoelek tronen bewirken keine Verfälschung der mit Hilfe des Gegenfeld-Spektrometers SP durchgeführten Potentialmessung, da deren mittlere kinetische Energie (E = 1 bis 2 eV) nicht ausreicht, die auf etwa - 8 Volt liegende Gegenfeldelektrode zu passieren.

Infolge der Bestrahlung der Probe mit Licht tritt außer dem durch Emission von Fotoelektronen gekennzeichneten äußeren Fotoeffekt auch ein innerer Fotoeffekt auf, bei dem Valenzelektronen durch Absorbtion von Photonen in das Leitungsband angehoben werden. Die hierdurch hervorgerufene strahlinduzierte Leitfähigkeit fördert zwar den Abbau elektrischer Aufladungen, kann aber die Untersuchung mikroelektronischer Bauelemente empfindlich stören, da insbesondere VLSI-Schaltungen durch hohe Fotoströme geschädigt bzw. in ihrer Funktion in nicht vorhersehbarer Weise beeinflußt werden. Um abzuschätzen, welche UV-Bestrahlungsdosen für aufladungsfreie Untersuchungen integrierter Schaltungen nicht mehr tolerabel sind, kann man beispielsweise die zur Löschung eines Speichers notwendige UV-Bestrahlungsdosis oder die einen erhöhten Bauelementausfall verursachende Gammadosis heranziehen. Eine Klärung dieser Frage ist letztendlich nur durch das Experiment möglich, da die tolerable UV-Dosis auch noch stark von der Technologie des jeweiligen IC's abhängt. Unkritisch sind Untersuchungen an allen gegenüber UV-Licht unempfindlichen Proben. Aus dem Bereich der Mikroelektronik sind hierbei insbesondere die nur aus metallischen Leiterbahnen und unempfindlichen Keramiken bzw. Kunststoffen bestehenden Mikroverdrahtungsplatten zu nennen.

In Abwandlung zu dem in Fig. 1 dargestellten Ausführungsbeispiel kann die Strahlungsquelle Q, beispielsweise eine UV-Lampe auch innerhalb der Probenkammer PK angeordnet werden. In diesem Fall ist eine Optik zur Fokussierung der Strahlung PH auf die Probe PR nicht mehr notwendig, so daß sich der Aufbau der Anordnung wesentlich vereinfacht. Es ist selbstverständlich auch möglich, die Probe PR ohne Zwischenschaltung von Lichtleitern, beispielsweise durch ein in die Wandung der Probenkammer PK eingelassenes vakuumdichtes Quarzglasfenster, zu beleuchten.

Die Erfindung ist selbstverständlich nicht nur im Rahmen der Rasterelektronenmikroskopie und der Elektronenstrahlmeßtechnik anwendbar. Von besonderer Bedeutung sind vielmehr alle Bereiche, in denen Aufladungen einer Probe durch einen abtastenden Elektronen-oder Ionenstrahl vermieden werden müssen. Hierbei sind insbesondere die Inspektion und Vermessung von Oberflächenstrukturen, die Durchgangsprüfung von Mikroverdrahtungen und die Materialanalyse (Augerspektroskopie) zu nennen.

Bezugszeichenliste A     Anode

AS      Ablenksystem

BBG     Pulsgenerator (Beam-Blanking Generator)

BBS     Strahlaustastsystem (Beam-Blanking-System)

CRT     Sichtgerät (Cathode-Ray-Tube)

DT      Detektoreinheit

K     Kathode

K1 / K2     Kondensorlinsen

M     Spiegel

OL      Objektivlinse

PE      Primärelektronenstrahl

PH      Strahlung (Photonen)

PK      Probenkammer

PM      Primärspiegel

PR      Probe

Q     Strahlungsquelle

REM     Rasterelektronenmikroskop

SE      Sekundärelektronen

SP      Gegenfeld-Spektrometer

SM      Sekundärspiegel

SV      Anordnung zur Signalverarbeitung

W     Wehnelt-Elektrode

## Ansprüche

1. Verfahren zur aufladungsfreien Untersuchung einer Probe, bei der mindestens ein Punkt oder ein Teil der Probenoberfläche mit einem Korpuskularstrahl abgetastet wird und bei der zumindest der abgetastete Oberflächenbereich mit Photonen bestrahlt wird. dadurch **gekennzeichnet,** daß die Probe (PR) mit Korpuskeln (PE) beaufschlagt wird, deren Energie ($E_{PE}$ ) so gewählt ist, daß sich der jeweils abgetastete Oberflächenbereich negativ auflädt und daß die Bestrahlung mit Photonen (PH) erfolgt, deren Wellenlänge kleiner als die Grenzwellenlänge des Probenmaterials für den äußeren Fotoeffekt ist.

2. Verfahren nach Anspruch 1, dadurch **gekennzeichnet,** daß die Energie ($E_{PE}$) der Korpuskeln (PE) oberhalb der höchsten Grenzenergie ($E_2$) aller Oberflächenmaterialien liegt, bei der der auf die Probe (PR) auftreffende Strom der primären Korpuskeln und der von der Probe (PR) ausgehende Strom der rückgestreuten und sekundären Korpuskeln entgegengesetzt gleich sind.

3. Verfahren nach Anspruch 1 oder 2, dadurch **gekennzeichnet,** daß die Probe (PR) durch das abbildende Linsensystem (OL) eines Korpuskularstrahlgerätes (REM) mit Photonen (PH) bestrahlt wird.

4. Verfahren nach einem der Ansprüche 1 bis 3, dadurch **gekennzeichnet,** daß die Photonen (PH) in den Strahlengang der korpuskularoptischen Einheit des Korpuskularstrahlgerätes (REM) eingekoppelt und mit Hilfe einer Optik (M, PM, SM) auf die Probe (PR) abgebildet werden.

5. Verfahren nach Anspruch 1 oder 2, dadurch **gekennzeichnet,** daß die Photonen (PH) über Lichtleiter an die Probe (PR) herangeführt werden.

6. Verfahren nach Anspruch 1 oder 2, dadurch **gekennzeichnet,** daß die Photonen (PH) innerhalb der Probenkammer (PK) eines Korpuskularstrahlgerätes (REM) erzeugt werden.

7. Verfahren nach Anspruch 1 oder 2, dadurch **gekennzeichnet,** daß die Probe (PR) durch ein in die Wandung der Probenkammer (PK) eines Korpuskularstrahlgerätes (REM) eingelassenes Fenster mit Photonen (PH) bestrahlt wird.

8. Verfahren nach einem der Ansprüche 1 bis 7, dadurch **gekennzeichnet,** daß die Probe (PR) mit ultraviolettem Licht (PH) bestrahlt wird.

9. Anordnung zur aufladungsfreien Untersuchung einer Probe mit einem Korpuskularstrahlerzeuger, einer korpuskularoptischen Einheit zur Fokussierung eines Korpuskularstrahles auf eine Probe und einer Photonenquelle, **gekennzeichnet** durch eine innerhalb der korpuskularoptischen Einheit angeordneten Optik (M, PM, SM) zur Abbildung der Photonen (PH) auf die Probe (PR).

10. Anordnung nach Anspruch 9, dadurch **gekennzeichnet,** daß die Optik (M, PM, SM) im Strahlengang oberhalb der die Korpuskeln (PE) auf die Probe (PR) abbildenden Komponente (OL) der korpuskularoptischen Einheit angeordnet ist.

11. Anordnung nach Anspruch 9 oder 10, **gekennzeichnet** durch ein Cassegrain-Spiegelsystem als Optik zur Abbildung der Photonen (PH) auf die Probe (PR).

# FIG 1

# FIG 2